# EUROPEAN PATENT APPLICATION

(11) **EP 4 749 758 A1**
(43) Date of publication of application: **27.05.2026**
(21) Application number: 25200859.4
(22) Date of filing: 08.09.2025
(51) Int. Cl.: H01M 10/42

(54) **BATTERY PACK AND COMMUNICATION METHOD THEREOF**

(30) Priority: 26.11.2024 KR 20240170963
(71) Applicant: SAMSUNG SDI CO., LTD., Yongin-si, Gyeonggi-do 17084 (KR)
(72) Inventor: KIM, Min Su, 16678 Suwon-si (KR)
(74) Representative: Marks & Clerk LLP

(57) **Abstract**

The present disclosure relates to a battery pack (100) and a communication method thereof, and a technical problem to be solved is to propose a mechanism that enables a master battery management system (BMS) (30) and a plurality of slave BMSs (200) to perform surface plasmon resonance (SPR)-based optical communication. To this end, the present disclosure is directed to providing a configuration in which a nano-structured surface is formed on an inner side of an upper cover of a pack case (110), and the nano-structured surface allows a slave BMS (200) and a master BMS (30) to perform SPR-based optical communication.

## Description

### FIELD

The present disclosure relates to a battery pack and a communication method thereof.

### BACKGROUND

A battery system applied to an electrical vehicle or the like may include a plurality of battery packs each of which includes battery modules and a slave battery management system (BMS) that manages the battery modules. Further, the battery system may further include a master BMS that communicates with a vehicle system and manages the plurality of battery packs. In most battery packs, wired BMSs are used, but the use of wired BMSs causes problems such as increased weight, decreased reliability, and difficulty in maintenance due to complex wiring.

Accordingly, recently, in order to solve problems such as failures due to the quality of electrical wiring related to wire cables and connectors, frequent maintenance, etc., and to reduce the weight of electric vehicles and increase mileage, research and development on methods of wirelessly communicating between a master BMS and a plurality of slave BMSs has been increasingly conducted.

The herein information disclosed in this Background section is for enhancement of understanding of the background of the present disclosure, and therefore, it may contain information that does not constitute related (or prior) art.

### SUMMARY

The present disclosure is directed to providing a battery pack that allows a master battery management system (BMS) and a plurality of slave BMSs to perform surface plasmon resonance (SPR)-based optical communication, and a communication method.

However, objects that the present disclosure intends to achieve are not limited to the herein-described objects and other objects that are not described may be clearly understood by those skilled in the art from the following description.

According to an aspect there is provided a battery pack including, a pack case, a plurality of battery modules mounted inside the pack case, a plurality of slave battery management systems (BMSs) that are each mounted on one of the battery modules and collect battery state data of each battery module, and a master BMS configured to receive the battery state data from the plurality of slave BMSs through optical communication and integrate and manage the battery state data, wherein a nano-structured surface is formed on an inner side of an upper cover of the pack case, and the slave BMSs and the master BMS perform SPR-based optical communication. The slave and master BMSa may perform SPR based optical communication, for example, by propagating an optical signal using the nano-structured surface.

A hexagonal lattice structure may be formed on the nano-structured surface.

Each slave BMS may include, a first optical communication unit for SPR-based optical communication, a measurement unit that measures the battery state data of each battery module, and a first control unit that transmits the measured battery state data to the master BMS through the first optical communication unit and performs an operation corresponding to a control command received from the master BMS through the first optical communication unit.

The first optical communication unit may include, a first light source unit that is implemented as a vertical cavity surface emitting laser (VCSEL) and outputs light, a first plasmon coupler that converts an optical signal into a surface plasmon polariton (SPP) signal using the light output from the first light source unit, propagates the converted SPP signal, and converts an SPP signal received from the master BMS into an optical signal, and a first light detection unit that converts the optical signal converted by the first plasmon coupler into an electrical signal.

The SPP signal converted by the first plasmon coupler may be propagated along the nano-structured surface of the pack case and amplified through a radial nano-channel.

The first light detection unit may be implemented as a PIN photodiode.

The first control unit may packetize the battery state data and convert the packetized battery state data into an optical signal using the light output from the first light source unit.

The first control unit may receive the electrical signal from the first light detection unit, demodulate the received electrical signal, verify data integrity of the demodulated data, and when the data integrity is verified, perform the operation corresponding to the control command.

The master BMS may include, a second optical communication unit for SPR-based optical communication, and a second control unit that analyzes the battery state data received from the plurality of slave BMSs through the second optical communication unit, generates a control command on the basis of the analyzed battery state data, and transmits the control command to the plurality of slave BMSs through the second optical communication unit.

The second optical communication unit may include, a second light source unit that is implemented as a VCSEL and outputs light, a second plasmon coupler that converts an optical signal into an SPP signal using the light output from the second light source unit, propagates the converted SPP signal, and converts an SPP signal received from the slave BMS into an optical signal, and a second light detection unit that converts the optical signal converted by the second plasmon coupler into an electrical signal.

The SPP signal converted by the second plasmon coupler may be propagated along the nano-structured surface of the pack case and amplified through a radial nano-channel.

The second light detection unit may be implemented as a PIN photodiode.

The second control unit may receive the electrical signal from the second light detection unit, demodulate the received electrical signal, verify data integrity of the demodulated data, when the data integrity is verified, integrate the battery state data of the plurality of slave BMSs, generate a control command on a basis of the integrated data, and convert the control command into an optical signal using the light generated from the second light source unit.

The battery pack may further include a controller configured to apply a voltage to the upper cover of the pack case and change a refractive index of the nano-structured surface to modulate a phase of an SPP signal.

According to aspects of the present disclosure, there is provided a communication method of a battery pack, which includes measuring, by each of a plurality of slave BMSs, battery state data of each of battery modules and converting the measured battery state data into a first optical signal, converting, by each slave BMS, the first optical signal into a first SPP signal and propagating the first SPP signal along a nano-structured surface formed on an inner side of an upper cover of a pack case, receiving, by a master BMS, the first SPP signal and converting the received first SPP signal into a second optical signal, converting, by the master BMS, the second optical signal into an electrical signal, and analyzing, by the master BMS, the battery state data corresponding to the electrical signal.
At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a diagram schematically illustrating a configuration of a conventional battery pack;
FIG. 2 is a diagram schematically illustrating a configuration of a battery pack according to embodiments of the present disclosure;
FIG. 3 is an diagram for describing a pack case of the battery pack according to embodiments of the present disclosure;
FIGS. 4A to 4C are diagrams for describing a nano-structured surface formed on an inner side of an upper cover of the pack case according to embodiments of the present disclosure;
FIG. 5 is a block diagram schematically illustrating a configuration of a slave battery management system (BMS) according to embodiments of the present disclosure;
FIG. 6 is a block diagram schematically illustrating a configuration of a master BMS according to embodiments of the present disclosure; and
FIG. 7 is a flow diagram for describing a communication method of the slave BMS and the master BMS according to embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked," or "connected" to another element, the elements may be directly "coupled," "linked," or "connected" to each other, or an intervening element may be present therebetween, through which the element may be "coupled," "linked," or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

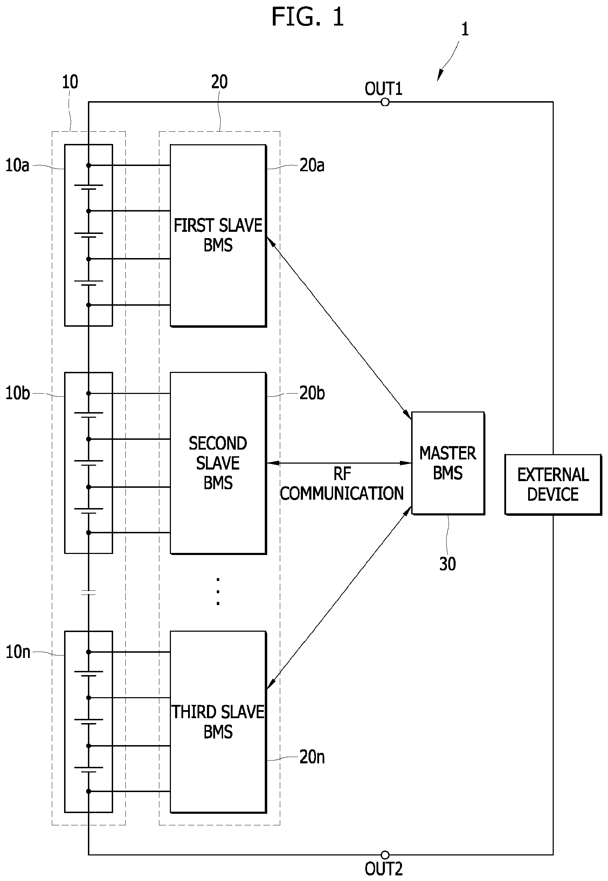

FIG. 1 is a diagram schematically illustrating a configuration of a conventional battery pack.

Referring to FIG. 1, a conventional battery pack 1 may include a plurality of battery modules 10a, 10b, ..., 10n (hereinafter referred to as "10"), a plurality of slave battery management systems (BMSs) 20a, 20b, ..., 20n (hereinafter referred to as "20"), and a master BMS 30.

The plurality of battery modules 10 may each include a plurality of battery cells connected in series and/or in parallel. In some embodiments, the battery cells may be rechargeable secondary batteries.

The plurality of slave BMSs 20 may be installed in a one-to-one correspondence with the plurality of battery modules 10. Each of the plurality of slave BMSs 20 may be electrically coupled to one battery module 10 that corresponds thereto and is any one of the plurality of battery modules 10. Therefore, the number of slave BMSs 20 may be equal to the number of battery modules 10.

The slave BMS 20 may measure battery state data on the battery module 10 electrically connected thereto. Here, the battery state data may include at least one of a cell voltage, a cell current, and a cell temperature of each battery cell included in each battery module 10. Further, the battery state data may include at least one of a module voltage, which is a voltage at both ends of the battery module 10, and a module current, which is a current flowing through the battery module 10.

The slave BMS 20 may include a wireless communication unit (not illustrated) and transmit the measured battery state data to the master BMS 30 through the wireless communication unit.

Further, the slave BMS 20 may perform a cell balancing function on the battery cells included in the battery module 10.

The master BMS 30 may wirelessly communicate with each of the plurality of slave BMSs 20 to transmit various types of control signals or receive the battery state data.

The master BMS 30 may include a wireless communication unit (not illustrated), receive the battery state data of the battery module 10 from each of the plurality of slave BMSs 20 through the wireless communication unit, and integrate and manage the battery state data.

The wireless communication units of the slave BMS 20 and master BMS 30 include a radio frequency integrated circuit (RFIC) and may perform wireless communication on the basis of radio frequency (RF) signals.

However, the RF-based wireless communication is vulnerable to electromagnetic interference, signal attenuation is severe in battery pack environments surrounded by metal, and high-speed large data transmission therethrough has limitations, and real-time monitoring and control thereof are difficult.

Accordingly, the present disclosure proposes a technology that enables high-speed optical communication between a slave BMS 200 and a master BMS 300 on the basis of surface plasmon resonance (hereinafter referred to as "SPR"). SPR may be an electromagnetic phenomenon occurring at a metal-dielectric interface. SPR may be a process in which free electrons on a metal surface collectively vibrate, the vibration is combined with an electromagnetic wave (light) to form a surface plasmon polariton (SPP), and the SPP is propagated along the metal surface.

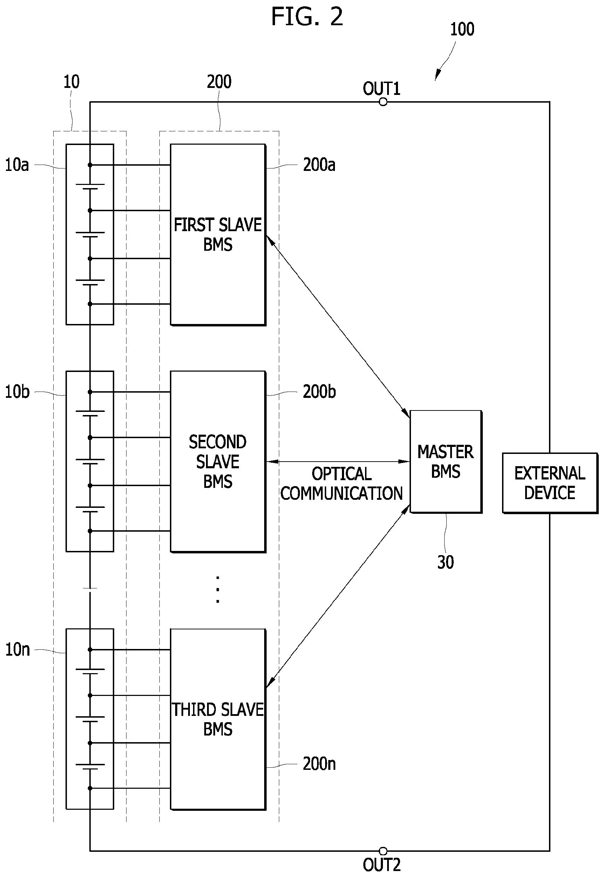

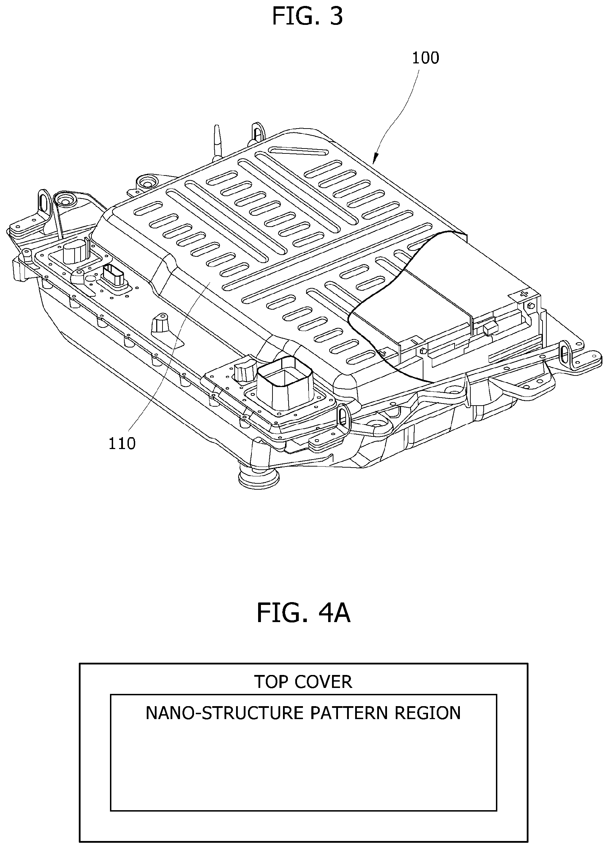

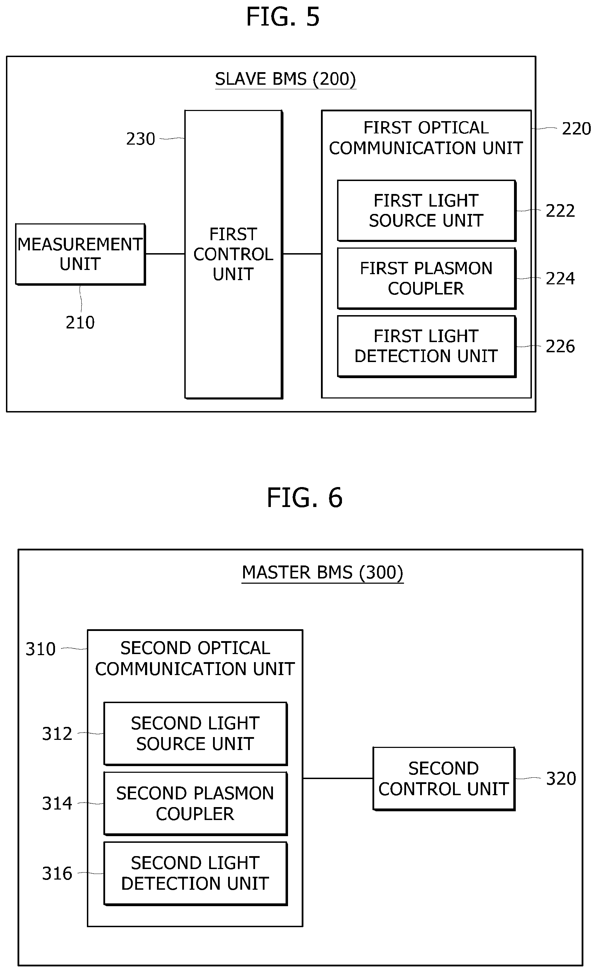

FIG. 2 is a diagram schematically illustrating a configuration of a battery pack according to embodiments of the present disclosure, FIG. 3 is an diagram for describing a pack case of the battery pack according to embodiments of the present disclosure, FIGS. 4A to 4C are diagrams for describing a nano-structured surface formed on an inner side of an upper cover of the pack case according to embodiments of the present disclosure, FIG. 5 is a block diagram schematically illustrating a configuration of a slave BMS according to embodiments of the present disclosure, and FIG. 6 is a block diagram schematically illustrating a configuration of a master BMS according to embodiments of the present disclosure.

Referring to FIG. 2, a battery pack 100 according to embodiments of the present disclosure include a plurality of battery modules 10a, 10b, ..., 10n (hereinafter referred to as "10"), a plurality of slave BMSs 200a, 200b, ..., 200n (hereinafter referred to as "200"), and a master BMS 300.

The battery pack 100 includes a pack case 110 that may form an exterior thereof. The plurality of battery modules 10, the plurality of slave BMSs 200, and the master BMS 300 may be mounted inside the pack case 110 of the battery pack 100 as illustrated in FIG. 3.

Meanwhile, the slave BMSs 200 and the master BMS 300 should be able to perform high-speed optical communication on the basis of SPR. Accordingly, the present disclosure may form so that an inner side of an upper cover of the pack case 110 of the battery pack 100 can resonate a nano-structured surface plasmon. That is, a nano-structured surface may be formed on the inner side of the upper cover of the pack case 110. In this case, the nano-structured surface may be formed using nanoimprint lithography.

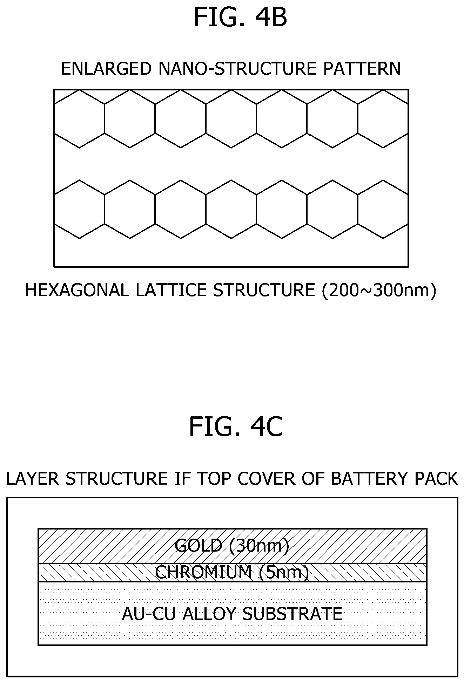

A nano-structure pattern region is present on the inner side of the upper cover of the pack case 110 as illustrated in FIG. 4A. A hexagonal lattice structure (pattern) may be formed in the nano-structure pattern region as illustrated in FIG. 4B. In the hexagonal lattice structure (pattern), sizes of hexagonal cells may be 200 to 300 nm, intervals between the hexagonal cells may be 50 to 100 nm, and depths of the hexagonal cells may be 50 to 100 nm. The hexagonal lattice structure (pattern) may be a structure that promotes the formation and propagation of an SPP signal. Such a nano-structure pattern may be a structure in which an Al-Cu alloy substrate is first coated with chromium and secondarily coated with gold, as illustrated in FIG. 4C. By performing coating with chromium first, the adhesion may be improved, and by performing coating with gold second, an SPR effect may be optimized. In this case, the substrate may be coated with chromium and gold by sputtering. The nano-structure pattern formed on the inner side of the upper cover of the pack case 110 may form a radial nano-channel. The radial nano-channel may mean a hexagonal lattice structure. The radial nano-channel may have a width of 500 nm and a depth of 100 nm and extend radially starting from light source units 222 and 312 and light detection units 226 and 316 of the slave BMS 200 and master BMS 300.

When power is applied to the battery pack 100, the power may be supplied to the master BMS 300 and the plurality of slave BMSs 200. When the power is supplied to the master BMS 300 and the plurality of slave BMSs 200, the master BMS 300 and the plurality of slave BMSs 200 may each perform self-diagnosis. When the self-diagnosis is completed, the master BMS 300 may initialize a SPR-based optical network and assign a unique ID to each slave BMS 200. Further, the master BMS 300 may broadcast accurate time information to perform time synchronization with the plurality of slave BMSs 200.

The plurality of battery modules 10 may each include a plurality of battery cells connected in series and/or in parallel. In some embodiments, the battery cells may be rechargeable secondary batteries.

The plurality of slave BMSs 200 may be installed in a one-to-one correspondence with the plurality of battery modules 10. Each of the plurality of slave BMSs 200 may be electrically coupled to one battery module 10 that corresponds thereto and is any one of the plurality of battery modules 10. Therefore, the number of slave BMSs 200 may be equal to the number battery modules 10.

For example, a first slave BMS 200a may be electrically coupled to a first battery module 10a, a second slave BMS 200b may be electrically coupled to a second battery module 10b, and a third slave BMS 200c may be electrically coupled to a third battery module 10c.

The slave BMS 200 may measure battery state data on the battery module 10 electrically connected thereto and transmit the measured battery state data to the master BMS 300 through optical communication. Here, the battery state data may include at least one of a cell voltage, a cell current, and a cell temperature of each battery cell included in each battery module 10. Further, the battery state data may include at least one of a module voltage, which is a voltage at both ends of the battery module 10, and a module current, which is a current flowing through the battery module 10.

When an abnormality such as a sudden temperature rise or the like is detected, the slave BMS 200 may transmit a warning signal to the master BMS 300 through a first optical communication unit 220. Then, the master BMS 300 may transmit an emergency control command to the corresponding slave BMS 200 through a second optical communication unit 310.

The slave BMS 200 may perform optical communication with the master BMS 300 using its own pre-assigned ID, and the master BMS 300 may store the ID pre-assigned to the slave BMS 200. Here, the ID may be identification information for distinguishing the plurality of slave BMSs.

The slave BMS 200 may include a measurement unit 210, a first optical communication unit 220, and a first control unit 230 as illustrated in FIG. 5.

The measurement unit 210 may measure the battery state data such as a voltage, a current, a temperature, etc. of the battery module 10 and transmit the battery state data to the first control unit 230.

The measurement unit 210 may measure a cell voltage of each of the plurality of battery cells. For example, the measurement unit 210 may measure a voltage at both ends of each of the plurality of battery cells to measure a cell voltage of each battery cell. In this case, the measurement unit 210 may measure the cell voltage of each battery cell in various forms, and the present disclosure is not limited by this voltage measurement method.

The measurement unit 210 may measure a cell current flowing into or out of each of the plurality of battery cells and transmit the measured cell current to the first control unit 230.

The measurement unit 210 may measure a temperature of the battery module 10 and transmit the measured temperature to the first control unit 230.

Accordingly, the measurement unit 210 may include a voltage sensor configured to measure the cell voltage of each of the plurality of battery cells. Further, the measurement unit 210 may include a current sensor configured to measure the cell current of each of the plurality of battery cells. Further, the measurement unit 210 may include a temperature sensor configured to measure the temperature of the battery module 10. The temperature sensor may be disposed within a predetermined distance from the battery module 10 to measure the temperature of the battery module 10.

The measurement unit 210 may be electrically connected to the battery module 10 to collect the battery state data. For example, the measurement unit 210 may be composed of an application specific Integrated Circuit (ASIC), a battery monitoring IC (BMIC), etc. as an IC that may collect the battery state data.

The first optical communication unit 220 may be a component for SPR-based optical communication.

The first optical communication unit 220 may convert an optical signal generated by the first control unit 230 into an SPP signal and propagate the converted SPP signal along a nano-structured surface formed on the inner side of the upper cover of the pack case 110. Further, the first optical communication unit 220 may convert the SPP signal transmitted from the master BMS 300 into an optical signal, convert the converted optical signal into an electrical signal, and transmit the converted electrical signal to the first control unit 230.

The first optical communication unit 220 may include a first light source unit 222, a first plasmon coupler 224, and a first light detection unit 226.

The first light source unit 222 is a component that outputs light and may be implemented as, for example, a vertical cavity surface emitting laser (VCSEL).

In the first light source unit 222, a plurality of channels may be formed in a horizontal direction in addition to a plurality of channels formed in a vertical direction by an array of a plurality of dot-shaped convex lenses for laser beam (light) transmitted from the VCSEL. Here, the VCSEL may be a semiconductor laser diode, which is variously called a vertical cavity surface-emitting laser, a vertical cavity surface-emitting laser, a vertical cavity surface-emitting laser, a vertical hole surface-emitting laser, etc. The VCSEL may be formed so that the laser emitted in the vertical direction passes through a micro-array lens (a micro lens array or a VCSEL lens) formed on an upper surface and evenly emits laser light in a certain pattern (dot) as a surface emission. The VCSEL may, for example, generate a wavelength of 850 nm, have an output of 1 to 2 mW, and have a modulation speed of up to 10 Gbps.

The first plasmon coupler 224 may convert the converted optical signal into an SPP signal using the laser beam (light) output from the first light source unit 222. Here, the first plasmon coupler 224 may be a grating coupler, and the grating coupler may have, for example, a period of about 600 nm that is optimized for a wavelength of 850 nm, a depth of 50 to 100 nm, and a width of 300 to 400 nm.

When a near-infrared laser beam with a wavelength of 850 nm is generated from the VCSEL, the first plasmon coupler 224 may convert the optical signal into the SPP signal by aligning the phase, adjusting the momentum of photons to match the momentum of surface plasmons, and coupling photon-plasmon. In this case, a grating period of the first plasmon coupler 224 may be about 600 nm, which is optimized for a wavelength of 850 nm, and the coupling efficiency of the photon-plasmon may be maximized by finely adjusting an incident angle.

The SPP signal converted by the first plasmon coupler 224 may be propagated along the nano-structured surface formed on the inner side of the upper cover of the pack case 110. That is, the SPP signal generated by the first plasmon coupler 224 may radially spread and may be propagated along the nano-structure pattern formed on the inner side of the upper cover of the pack case 110. In other words, the SPP signal generated by the first plasmon coupler 224 may radially spread and may be guided along the nano-structured surface formed on the inner side of the upper cover of the pack case 110. Therefore, the propagation direction of the SPP signal may be controlled by the nano-structure of the nano-structured surface. That is, the SPP signal may be guided along the nano-structured surface so that the hexagonal lattice of the nano-structured surface may control the direction of the SPP signal and the loss may be minimized. In other words, the SPP signal may be propagated along the nano-structured surface and amplified and guided through the radial nano-channel of the nano-structured surface. Here, the radial nano-channel of the nano-structured surface may serve as a main propagation path.

Further, when the SPP signal is propagated along the nano-structured surface formed on the inner side of the upper cover of the pack case 110, a local electric field may be significantly amplified in a gap between the nano-structures. This may maintain the strength of the SPP signal and enable long-distance propagation. Further, since SPP signals between adjacent nano-structures are coupled, a propagation distance of the SPP signals may extend and some energy may be re-radiated to form multi-path propagation.

The first plasmon coupler 224 may convert an SPP signal received from the master BMS 300 into an optical signal.

The first light detection unit 226 may convert the optical signal converted by the first plasmon coupler 224 into an electrical signal. That is, the first light detection unit 226 may include an optical detection element that can detect an optical signal of a specific wavelength band and may convert the optical signal into the electrical signal and transmit the converted electrical signal to the first control unit 230.

The first light detection unit 226 may include a light receiving sensor implemented as, for example, any one of a PIN photodiode, an avalanche photodiode (APD), and a silicon photomultiplier (SiPM).

The first optical communication unit 220 formed as described herein may multiplex a frequency domain. That is, the first optical communication unit 220 may use VCSELs of multiple wavelengths to transmit SPP signals simultaneously through multiple channels. In this case, a unique frequency band may be assigned to each slave BMS 200.

The first control unit 230 may transmit the battery state data measured through the measurement unit 210 to the master BMS 300 through the first optical communication unit 220.

To this end, the first control unit 230 may packetize and encrypt the battery state data. In this case, the first control unit 230 may add an error detection code to the packetized data and encrypt the data to which the error detection code is added.

The first control unit 230 may convert the battery state data into an optical signal using the light (laser beam) generated from the first light source unit 222. In this case, the first control unit 230 may modulate the electrical signal for the battery state data into the optical signal using various modulation methods such as on-off keying (OOK), pulse amplitude modulation (PAM)-4, etc.

The optical signal modulated by the first control unit 230 may be converted into an SPP signal through the first plasmon coupler 224, and the SPP signal may be propagated along the nano-structured surface formed on the inner side of the upper cover of the pack case 110.

The first control unit 230 may perform an operation corresponding to a control command received from the master BMS 300 through the first optical communication unit 220.

To this end, the first control unit 230 may receive an electrical signal from the first light detection unit 226 and analyze the received electrical signal to verify the control command.

Specifically, the first control unit 230 may demodulate the electrical signal and perform an error check on the demodulated data to verify data integrity. In this case, the first control unit 230 may perform, for example, a cyclic redundancy check (CRC) to verify the integrity of the demodulated data. When an error is found according to a result of the error check, the first control unit 230 may request retransmission of the battery state data from the master BMS 300.

When the integrity of the data is verified, the first control unit 230 may perform an operation corresponding to the demodulated data (e.g., the control command). For example, the first control unit 230 may perform an operation corresponding to a control command such as cell balancing, current control for battery cells, or the like included in the battery module 10.

In this way, the first control unit 230 may transmit the battery state data to the master BMS 300 through the first optical communication unit 220 and receive the control command related to monitoring or cell balancing from the master BMS 300 through the first optical communication unit 220.

The first control unit 230 is a subject that controls an operation of the slave BMS 200, and may be implemented as a central processing unit (CPU) or a system on chip (SoC), and may control a plurality of hardware or software components connected to the first control unit 230 by running an operating system or application and perform various data processing and operations.

The master BMS 300 is a component that integrates and controls the plurality of slave BMSs 200 and may be operatively coupled to the plurality of slave BMSs 200 through optical communication.

The master BMS 300 may receive the battery state data from the plurality of slave BMSs 200 through optical communication to integrate and manage the battery state data, and measure at least one of a battery pack voltage and a battery pack current to diagnose the state of the battery pack 100.

The master BMS 300 may transmit various types of control commands or receive the battery state data through optical communication with each of the plurality of slave BMSs 200. The master BMS 300 may calculate a state of charge (SOC), a state of health (SOH), etc., of each battery module 10 or determine whether each battery module 10 has overvoltage or undervoltage or is overcharged or over-discharged on the basis of the battery state data received from the slave BMS 200.

The master BMS 300 may be connected to an upper-level controller (not illustrated). The master BMS 300 may transmit information on the state and control of the battery to the upper controller or control an operation of the battery pack 100 on the basis of a control signal received from the upper controller. The master BMS 300 may communicate with the upper controller to receive a command and information and manage and control at least one slave BMS 200 included in the battery pack 100 according to the received command. Here, the upper controller may be a control unit of an upper-level system (e.g., a car, an energy storage system (ESS), etc.) in which the battery pack 100 is mounted.

The master BMS 300 may periodically check a response of each slave BMS 200, and when a non-responsive slave BMS 200 is detected, attempt to reconnect to the corresponding slave BMS 200, and thus the connectivity between the slave BMS 200 and the master BMS 300 may be checked.

The master BMS 300 may set an optimal path with the slave BMS 200 on the basis of a signal strength. When a failure occurs in the slave BMS 200, the master BMS 300 may switch the path of the corresponding slave BMS 200 to an alternative path.

The master BMS 300 may optimize communication performance by monitoring communication quality indicators. Here, the communication quality indicators may include, for example, a signal-to-noise ratio (SNR), a bit error rate (BER), etc.

The master BMS 300 may include a second optical communication unit 310 and a second control unit 320 as illustrated in FIG. 6.

The second optical communication unit 310 may be a component for SPR-based optical communication.

The second optical communication unit 310 may convert an optical signal generated by the second control unit 320 into an SPP signal and propagate the converted SPP signal along the nano-structured surface formed on the inner side of the upper cover of the pack case 110. Further, the second optical communication unit 310 may convert the SPP signal transmitted from the plurality of slave BMSs 200 into an optical signal, convert the converted optical signal into an electrical signal, and transmit the converted electrical signal to the second control unit 320.

The second optical communication unit 310 may include a second light source unit 312, a second plasmon coupler 314, and a second light detection unit 316.

The second light source unit 312 is a component that outputs light and may be implemented as, for example, a VCSEL. Since the second light source unit 312 is the same as the first light source unit 222, a detailed description thereof will be omitted.

The second plasmon coupler 314 may convert the converted optical signal into an SPP signal using the laser beam (light) output from the second light source unit 312. Here, the first plasmon coupler 224 may be a grating coupler, and the grating coupler may have, for example, a period of about 600 nm that is optimized for a wavelength of 850 nm, a depth of 50 to 100 nm, and a width of 300 to 400 nm.

When a near-infrared laser beam with a wavelength of 850 nm is generated from the VCSEL, the second plasmon coupler 314 may convert the optical signal into the SPP signal by aligning the phase, adjusting the momentum of the photon to match the momentum of the surface plasmon, and coupling photon-plasmon. In this case, a grating period of the second plasmon coupler 314 may be about 600 nm, which is optimized for a wavelength of 850 nm, and the coupling efficiency of the photon-plasmon may be maximized by finely adjusting an incident angle.

The SPP signal converted by the second plasmon coupler 314 may be propagated along the nano-structured surface formed on the inner side of the upper cover of the pack case 110. That is, the SPP signal generated by the second plasmon coupler 314 may radially spread and may be propagated along the nano-structure pattern formed on the inner side of the upper cover of the pack case 110. In other words, the SPP signal generated by the first plasmon coupler 224 may radially spread and may be guided along the nano-structured surface formed on the inner side of the upper cover of the pack case 110. Therefore, the propagation direction of the SPP signal may be controlled by the nano-structure of the nano-structured surface. That is, the SPP signal may be guided along the nano-structured surface so that the hexagonal lattice of the nano-structured surface may control the direction of the SPP signal and the loss may be minimized. In other words, the SPP signal may be propagated along the nano-structured surface and amplified and guided through the radial nano-channel of the nano-structured surface. Here, the radial nano-channel of the nano-structured surface may serve as a main propagation path.

Further, when the SPP signal is propagated along the nano-structured surface formed on the inner side of the upper cover of the pack case 110, a local electric field may be significantly amplified in a gap between the nano-structures. This may maintain the strength of the SPP signal and enable long-distance propagation. Further, since SPP signals between adjacent nano-structures are coupled, the propagation distance of the SPP signals may extend and some energy may be re-radiated to form multi-path propagation.

The second plasmon coupler 314 may convert an SPP signal received from the slave BMS 200 into an optical signal.

The second light detection unit 316 may convert the optical signal converted by the second plasmon coupler 314 into an electrical signal. That is, the second light detection unit 316 may include an optical detection element that can detect an optical signal of a specific wavelength band and may convert the optical signal into an electrical signal and transmit the converted electrical signal to the second control unit 320.

The second light detection unit 316 may be implemented as, for example, a PIN photodiode. The second light detection unit 316 may include a light receiving sensor implemented as, for example, any one of an APD and a SiPM.

The second optical communication unit 310 formed as described herein may multiplex a frequency domain. That is, the second optical communication unit 310 may use VCSELs of multiple wavelengths to transmit SPP signals simultaneously through multiple channels. In this case, a unique frequency band may be assigned to each slave BMS 200.

The second control unit 320 may analyze the battery state data received from the plurality of slave BMSs 200 through the second optical communication unit 310, generate a control command on the basis of the analyzed battery state data, and transmit the generated control command to the plurality of slave BMSs 200 through the second optical communication unit 310.

To this end, the second control unit 320 may receive the electrical signal from the second light detection unit 316, analyze the received electrical signal, and analyze the battery state data of each slave BMS 200.

Specifically, the second control unit 320 may demodulate the electrical signal received from the second light detection unit 316 and perform an error check on the demodulated data to verify data integrity. In this case, the second control unit 320 may perform a CRC, for example, to verify the integrity of the demodulated data. When an error is found according to a result of the error check, the second control unit 320 may request retransmission of the battery state data from the corresponding slave BMS 200.

When the integrity of the battery state data of each slave BMS 200 is verified, the second control unit 320 may integrate the battery state data of the respective slave BMSs 200 and calculate the state of the entire battery pack 100 on the basis of the integrated data. For example, the second control unit 320 may calculate an SOC, an SOH, etc. of each battery module 10 or determine whether each battery module 10 has overvoltage or undervoltage or is overcharged or over-discharged using the integrated data. Further, the second control unit 320 may apply the integrated data to a machine learning algorithm to perform abnormality detection, lifetime prediction, etc.

The second control unit 320 may generate a control command on the basis of the integrated data.

The second control unit 320 may packetize and encrypt the control command. In this case, the second control unit 320 may add an error detection code to the packetized data and encrypt the data to which the error detection code is added.

The second control unit 320 may convert the control command into an optical signal using the light (laser beam) generated from the second light source unit 312. In this case, the second control unit 320 may modulate the electrical signal for the control command into the optical signal using various modulation methods such as OOK, PAM-4, etc.

The optical signal modulated by the second control unit 320 may be converted into an SPP signal through the second plasmon coupler 314, and the SPP signal may be propagated along the nano-structured surface formed on the inner side of the upper cover of the pack case 110. The SPP signal propagated along the nano-structured surface formed on the inner side of the upper cover of the pack case 110 may be received by the plurality of slave BMSs 200.

The second control unit 320 is a subject that controls an operation of the master BMS 300, may be implemented as a CPU or a SoC, may control a plurality of hardware or software components connected to the second control unit 320 by running an operating system or application, and may perform processing and operation on various types of data .

Meanwhile, although not illustrated in FIG. 2, the battery pack may further include a controller (not illustrated) that can apply a voltage to the upper cover of the pack case 110 and change a refractive index of the nano-structured surface to modulate a phase of the SPP signal. Since the change in the refractive index of the nano-structured surface itself affects a propagation speed of the SPP signal, a phase of the SPP signal may be modulated by changing the refractive index.

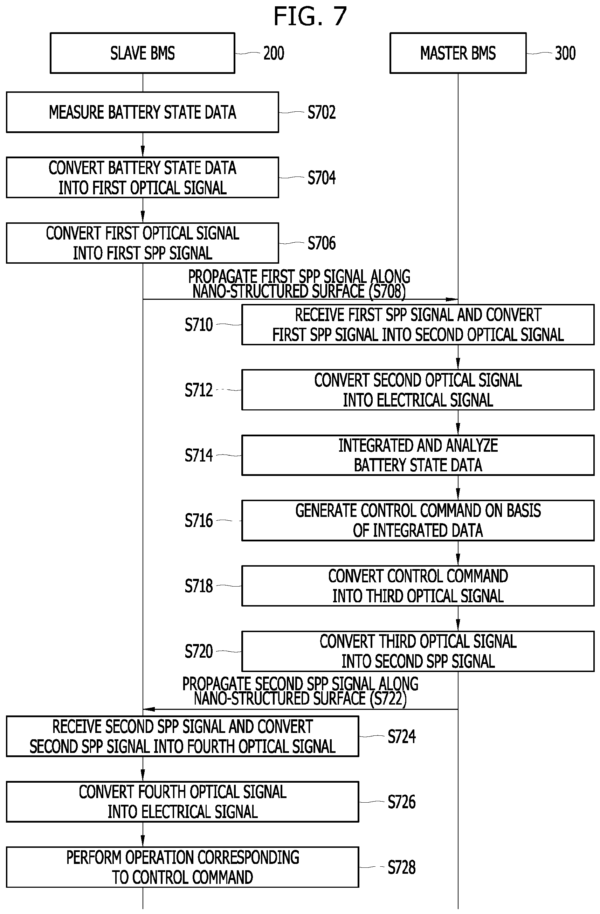

FIG. 7 is a diagram for describing a communication method of the slave BMS and the master BMS according to embodiments of the present disclosure.

Referring to FIG. 7, the slave BMSs 200 measures battery state data such as a voltage, a current, a temperature, etc., of each corresponding battery module 10 (S702) and converts the measured battery state data into a first optical signal (S704). In this case, the slave BMS 200 may normalize and packetize the battery state data and add an error detection code to the packetized battery state data. Thereafter, the slave BMS 200 may convert the packetized battery state data into the first optical signal using a laser beam generated from a VCSEL.

After operation S704 is performed, the slave BMS 200 converts the first optical signal into a first SPP signal through the first plasmon coupler 224 (S706) and propagates the first SPP signal along the nano-structured surface of the upper cover (S708). That is, when a laser beam is generated from the VCSEL of the slave BMS 200, the first plasmon coupler 224 may convert the first optical signal into the first SPP signal by aligning a phase, adjusting the momentum of photons to match the momentum of surface plasmons, and coupling photon-plasmon. The first SPP signal generated by the first plasmon coupler 224 may radially spread and may be guided along the nano-structured surface formed on the upper cover of the pack case 110.

After operation S708 is performed, the master BMS 300 receives the first SPP signal through the second plasmon coupler 314 and converts the received first SPP signal into a second optical signal (S710) and converts the second optical signal converted by the second plasmon coupler 314 into an electrical signal through the second light detection unit 316 (S712).

After operation S712 is performed, the master BMS 300 demodulates the electrical signal to analyze the battery state data (S714) and generates a control command on the basis of the analyzed battery state data (S716). That is, the master BMS 300 may demodulate the electrical signal and perform an error check on the demodulated data to verify data integrity. When an error is found according to a result of the error check, the second control unit 320 may request retransmission of the battery state data from the corresponding slave BMS 200. When the integrity of the battery state data of each slave BMS 200 is verified, the master BMS 300 may integrate the battery state data of the respective slave BMSs 200 and generate a control command on the basis of the integrated data.

After operation S716 is performed, the master BMS 300 converts the generated control command into a third optical signal (S718). In this case, the master BMS 300 may packetize and encrypt the control command. Thereafter, the master BMS 300 may convert the control command into the third optical signal using the light (laser beam) generated from the second light source unit 312. In this case, the master BMS 300 may modulate the electrical signal for the control command into the third optical signal using various modulation methods such as OOK, PAM-4, etc.

After operation S718 is performed, the master BMS 300 converts the third optical signal into a second SPP signal through the second plasmon coupler 314 (S720), and propagates the second SPP signal along the nano-structured surface of the upper cover (S722). That is, when a laser beam is generated from the VCSEL of the master BMS 300, the second plasmon coupler 314 may convert the third optical signal into the second SPP signal by aligning a phase, adjusting the momentum of photons to match the momentum of surface plasmons, and coupling photon-plasmon. The second SPP signal generated by the second plasmon coupler 314 may radially spread and may be guided along the nano-structured surface formed on the upper cover of the pack case 110.

After operation S722 is performed, the slave BMS 200 receives the second SPP signal through the first plasmon coupler 224 and converts the second first SPP signal into a fourth optical signal (S724) and converts the fourth optical signal converted by the first plasmon coupler 224 into an electrical signal through the first light detection unit 226 (S726).

After operation S726 is performed, the slave BMS 200 demodulates the electrical signal and performs an operation corresponding to the control command (S728). That is, the slave BMS 200 may demodulate the electrical signal and perform an error check on the demodulated data to verify data integrity. When an error is found according to a result of the error check, the slave BMS 200 may request retransmission of the control command from the master BMS 300. When the integrity of the control command is verified, the slave BMS 200 may perform the operation corresponding to the control command.

As described herein, according to the present disclosure, since a master BMS and a plurality of slave BMSs perform SPR-based optical communication, terahertz band data transmission is possible, a data collection cycle within 1 ms and a control cycle within 50 ms can be achieved, and thus significantly rapid data processing enables real-time monitoring of battery state and immediate response, which can improve the safety and performance of a battery pack.

According to the present disclosure, since an optical signal is propagated using a nano-structured surface formed on an inner side of an upper cover of a pack case of a battery pack, the battery pack is very resistant to external electromagnetic interference, thereby improving the reliability of communication and reducing accidents caused by malfunction of the battery pack.

According to the present disclosure, by utilizing SPR technology, high-speed communication at low power is possible so that the total power consumption of a battery pack can be reduced, and thus the power consumption of BMSs can be reduced, thereby improving the energy efficiency of the battery pack and, for example, increasing a driving distance of a vehicle.

According to the present disclosure, by performing SPR-based optical communication, high-resolution data collection of 14 bits or more is possible with very little noise in an optical manner so that the accuracy and reliability of sensor data can be increased, thereby improving the accuracy of battery state estimation, lifetime prediction, fault diagnosis, etc.

According to the present disclosure, with communication through a nano-structured surface, a battery pack is easily scalable regardless of the number or arrangement of battery modules 10, and the present disclosure can be easily applied to various battery pack configurations.

According to the present disclosure, complex wiring can be eliminated so that the assembly of a battery pack can be simplified, mass production can be facilitated by nanoimprint technology, and thus the production cost of the battery pack can be reduced and the maintenance time of the battery pack can be shortened.

According to the present disclosure, by immediately detecting and responding to dangerous situations such as overheating, overcharging, and short circuits through ultra-high-speed communication, the risk of battery-related accidents can be reduced.

According to the present disclosure, since a master BMS and a plurality of slave BMSs perform SPR-based optical communication, terahertz band data transmission is possible, a data collection cycle within 1 ms and a control cycle within 50 ms can be achieved, and thus significantly rapid data processing enables real-time monitoring of battery state and immediate response, which can improve the safety and performance of a battery pack.

According to the present disclosure, since an optical signal is propagated using a nano-structured surface formed on an inner side of an upper cover of a pack case of a battery pack, the battery pack is very resistant to external electromagnetic interference, thereby improving the reliability of communication and reducing accidents caused by malfunction of the battery pack.

According to the present disclosure, by utilizing SPR technology, high-speed communication at low power is possible so that the total power consumption of a battery pack can be reduced, and thus the power consumption of BMSs can be reduced, thereby improving the energy efficiency of the battery pack and, for example, increasing a driving distance of a vehicle.

According to the present disclosure, by performing SPR-based optical communication, high-resolution data collection of 14 bits or more is possible with very little noise in an optical manner so that the accuracy and reliability of sensor data can be increased, thereby improving the accuracy of battery state estimation, lifetime prediction, fault diagnosis, etc.

According to the present disclosure, with communication through a nano-structured surface, a battery pack is easily scalable regardless of the number or arrangement of battery modules 10, and the present disclosure can be easily applied to various battery pack configurations.

According to the present disclosure, complex wiring can be eliminated so that the assembly of a battery pack can be simplified, mass production can be facilitated by nanoimprint technology, and thus the production cost of the battery pack can be reduced and the maintenance time of the battery pack can be shortened.

According to the present disclosure, by immediately detecting and responding to dangerous situations such as overheating, overcharging, and short circuits through ultra-high-speed communication, the risk of battery-related accidents can be reduced.

However, effects that can be achieved through the present disclosure are not limited to the herein-described effects and other effects that are not described may be clearly understood by those skilled in the art from the detailed descriptions.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs without departing from the scope of the present disclosure.

## Claims

1. A battery pack comprising:
a pack case (110);
a plurality of battery modules (10) mounted inside the pack case (110);
a plurality of slave battery management systems, BMSs, (200) that are each mounted on one of the battery modules (10) and configured to collect battery state data of each battery module (10) ; and
a master BMS (30) configured to receive the battery state data from the plurality of slave BMSs (200) through optical communication and to manage the battery state data,
wherein a nano-structured surface is formed on an inner side of an upper cover of the pack case (110), and
the slave BMSs (200) and the master BMS (30) are configured to perform surface plasmon resonance, SPR,-based optical communication.

2. The battery pack of claim 1, wherein a hexagonal lattice structure is formed on the nano-structured surface.

3. The battery pack of claim 1 or 2, wherein each slave BMS includes:
a first optical communication unit (220) for SPR-based optical communication;
a measurement unit (210) configured to measure the battery state data of each battery module (10); and
a first control unit (230) configured to transmit the measured battery state data to the master BMS (30) through the first optical communication unit (220) and to perform an operation corresponding to a control command received from the master BMS (30) through the first optical communication unit (220).

4. The battery pack of claim 3, wherein the first optical communication unit (220) includes:
a first light source unit (222) that is implemented as a vertical cavity surface emitting laser, VCSEL, and outputs light;
a first plasmon coupler (224) configured to convert an optical signal into a surface plasmon polariton, SPP, signal using the light output from the first light source unit (222), propagate the converted SPP signal, and to convert an SPP signal received from the master BMS (30) into an optical signal; and
a first light detection unit (226) configured to convert the optical signal converted by the first plasmon coupler (224) into an electrical signal.

5. The battery pack of claim 4, wherein the first control unit (230) is configured to packetize the battery state data and convert the packetized battery state data into an optical signal using the light output from the first light source unit (222).

6. The battery pack of any one of claims 1 to 5, wherein the master BMS (30) includes:
a second optical communication unit (310) for SPR-based optical communication; and
a second control unit (320) that is configured to analyze the battery state data received from the plurality of slave BMSs (200) through the second optical communication unit (310), generate a control command on a basis of the analyzed battery state data, and to transmit the control command to the plurality of slave BMSs (200) through the second optical communication unit (310).

7. The battery pack of claim 6, wherein the second optical communication unit includes (310):
a second light source unit (312) that is implemented as a vertical cavity surface emitting laser, VCSEL, and outputs light;
a second plasmon coupler (314) that is configured to convert an optical signal into a surface plasmon polariton, SPP, signal using the light output from the second light source unit (312), propagate the converted SPP signal, and to convert an SPP signal received from the slave BMS (200) into an optical signal; and
a second light detection unit (316) configured to convert the optical signal converted by the second plasmon coupler (314) into an electrical signal.

8. The battery pack of claim 7, wherein the second control unit (320) is configured to receive the electrical signal from the second light detection unit (316), demodulate the received electrical signal, verify data integrity of the demodulated data and, when the data integrity is verified, to integrate the battery state data of the plurality of slave BMSs (200), generate a control command on a basis of the integrated data, and convert the control command into an optical signal using the light generated from the second light source unit (312).

9. The battery pack of any one of claims 1 to 8, further comprising a controller configured to apply a voltage to the upper cover of the pack case (110) and change a refractive index of the nano-structured surface to modulate a phase of an SPP signal.

10. A communication method of a battery pack, comprising:
measuring, by each of a plurality of slave battery management systems (200), BMSs, battery state data of each of battery modules (10) and converting the measured battery state data into a first optical signal;
converting, by each slave BMS (200), the first optical signal into a first surface plasmon polariton, SPP, signal and propagating the first SPP signal along a nano-structured surface formed on an inner side of an upper cover of a pack case (110);
receiving, by a master BMS (30), the first SPP signal and converting the received first SPP signal into a second optical signal;
converting, by the master BMS (30), the second optical signal into an electrical signal; and
analyzing, by the master BMS (30), the battery state data corresponding to the electrical signal.

11. The communication method of claim 10, wherein, in the converting of the first optical signal into the first optical signal, each slave BMS (200) converts the battery state data into the first optical signal using light output from a vertical cavity surface emitting laser, VCSEL.

12. The communication method of claim 10 or 11, wherein, in the propagating of the first SPP signal, each slave BMS (200) converts the first optical signal into the first SPP signal through a first plasmon coupler (224),
wherein each slave BMS (200) adjusts momentum of photons generated from a vertical cavity surface emitting laser, VCSEL, to match momentum of surface plasmons and generates the first SPP signal through photon-plasmon coupling, and
the first SPP signal is guided along the nano-structured surface so that a propagation direction of the first SPP signal is controlled by a nano-structure of the nano-structured surface.

13. The communication method of claim 10, 11, or 12, wherein, in the converting of the first SPP signal into the second optical signal, the master BMS (30) converts the first SPP signal into the second optical signal using a second plasmon coupler (314), and
in the converting of the second optical signal into the electrical signal, the master BMS (30) converts the second optical signal into the electrical signal using a PIN photodiode (316).

14. The communication method of any one of claims 10 to 13, further comprising:
after the analyzing of the battery state data,
generating, by the master BMS (30), a control command on a basis of the analyzed battery state data and converting the control command into a third optical signal;
converting, by the master BMS (30), the third optical signal into a third SPP signal and propagating the third SPP signal along the nano-structured surface formed on the inner side of the upper cover of the pack case (110);
receiving, by the slave BMS (200), the third SPP signal and converting the third SPP signal into a fourth optical signal; and
converting, by the slave BMS (200), the fourth optical signal into an electrical signal and performing an operation according to the control command corresponding to the electrical signal.

15. The communication method of claim 14, wherein, in the performing of the operation according to the control command,
the slave BMS (200) converts the fourth optical signal into the electrical signal using a PIN photodiode (316), demodulates the converted electrical signal, verifies data integrity of the demodulated data, and when the data integrity is verified, performs the operation corresponding to the control command.
